(19)

Europäisches Patentamt

European Patent Office

Office européen des brevets

(11) **EP 4 502 201 A1**

(12) **EUROPEAN PATENT APPLICATION**
published in accordance with Art. 153(4) EPC

(43) Date of publication:
05.02.2025 Bulletin 2025/06

(21) Application number: 23779187.6

(22) Date of filing: 02.03.2023

(51) International Patent Classification (IPC):
C22C 5/04 (2006.01)    C22C 9/00 (2006.01)
C22C 30/02 (2006.01)    C22C 19/03 (2006.01)
C22F 1/00 (2006.01)    C22F 1/08 (2006.01)
C22F 1/10 (2006.01)    C22F 1/14 (2006.01)
G01R 1/06 (2006.01)

(52) Cooperative Patent Classification (CPC):
C22C 5/04; C22C 9/00; C22C 19/03; C22C 30/02;
C22F 1/00; C22F 1/08; C22F 1/10; C22F 1/14;
G01R 1/06; G01R 1/067

(86) International application number:
PCT/JP2023/007722

(87) International publication number:
WO 2023/189157 (05.10.2023 Gazette 2023/40)

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(30) Priority: 29.03.2022 JP 2022052834

(71) Applicant: Yokowo Co., Ltd
Tokyo 101-0041 (JP)

(72) Inventor: SATO, Kenichi
Tomioka-Shi, Gunma 370-2495 (JP)

(74) Representative: Gunzelmann, Rainer
Wuesthoff & Wuesthoff
Patentanwälte und Rechtsanwalt PartG mbB
Schweigerstraße 2
81541 München (DE)

(54) **PROBE**

(57)    A probe including greater than 20 mass% and less than or equal to 60 mass% of Pd, greater than or equal to 3 mass% and less than 20 mass% of Ag, greater than or equal to 3 mass% and less than or equal to 50 mass% of Ni, and greater than or equal to 3 mass% and less than or equal to 74 mass% of Cu.

FIG. 1

EP 4 502 201 A1

**Description**

TECHNICAL FIELD

The present invention relates to a probe.

BACKGROUND ART

To inspect an inspection object such as an integrated circuit, the inspection object is electrically connected to an inspection substrate via a probe provided in a socket. The probe may contain an alloy of Pd, Ag, and Cu.

Patent Document 1 describes an example of an alloy of Pd, Ag, and Cu. The alloy disclosed in Patent Document 1 contains approximately 35% to 59% of Pd, 4% or more of Ag, and 16% or more and 50% or less of Cu.

RELATED DOCUMENT

PATENT DOCUMENT

Patent Document 1 U.S. Patent No. 1935897

SUMMARY OF THE INVENTION

TECHNICAL PROBLEM

The alloy of Pd, Ag, and Cu may be used as a material constituting a probe. However, when the distal end of a probe containing the alloy of Pd, Ag, and Cu alloy is repeatedly brought into contact with and electrically connected to a solder of the inspection object, there is a tendency that components such as Sn contained in the solder and components contained in the probe are diffused into each other due to factors such as Joule heat. The diffusion of the components contained in the probe may cause the distal end of the probe to be worn out. When the distal end of the probe is worn out, the contact resistance between the probe and the solder may fluctuate. Accordingly, the use of a probe containing an alloy of Pd, Ag, and Cu may result in the relatively large number of times of cleaning or replacement of the distal end of the probe and reduce the operation rate of the inspection step.

An example of an object of the present invention is to suppress diffusion of components contained in a probe into a solder. Other objects of the present invention will become apparent from the description of the present specification.

SOLUTION TO PROBLEM

An aspect of the present invention is a probe including:

greater than 20 mass% and less than or equal to 60 mass% of Pd;
greater than or equal to 3 mass% and less than 20 mass% of Ag;
greater than or equal to 3 mass% and less than or equal to 50 mass% of Ni; and
greater than or equal to 3 mass% and less than or equal to 74 mass% of Cu.

Another aspect of the present invention is a probe including:

greater than 20 mass% and less than or equal to 60 mass% of Pd;
greater than or equal to 20 mass% and less than or equal to 35 mass% of Ag;
greater than or equal to 7 mass% and less than or equal to 50 mass% of Ni; and
greater than or equal to 3 mass% and less than or equal to 53 mass% of Cu.

According to the above-described aspects of the present invention, it is possible to suppress diffusion of the components contained in the probe into a solder.

BRIEF DESCRIPTION OF THE DRAWINGS

[Fig. 1] A cross-sectional view showing a socket according to an embodiment.

[Fig. 2] A cross-sectional view showing a socket according to a first variant.
[Fig. 3] A cross-sectional view showing a probe according to a second variant.

DESCRIPTION OF EMBODIMENTS

Hereinafter, embodiments and variants of the present invention will be described with reference to the accompanying drawings. In all drawings, the same constituent elements are denoted by the same reference signs, and detailed description thereof will not be repeated.

In the present specification, ordinal numbers such as "first", "second", and "third" are attached only for distinguishing components to which the same names are attached unless otherwise specified and do not mean particular features (for example, an order or a degree of importance) of the components.

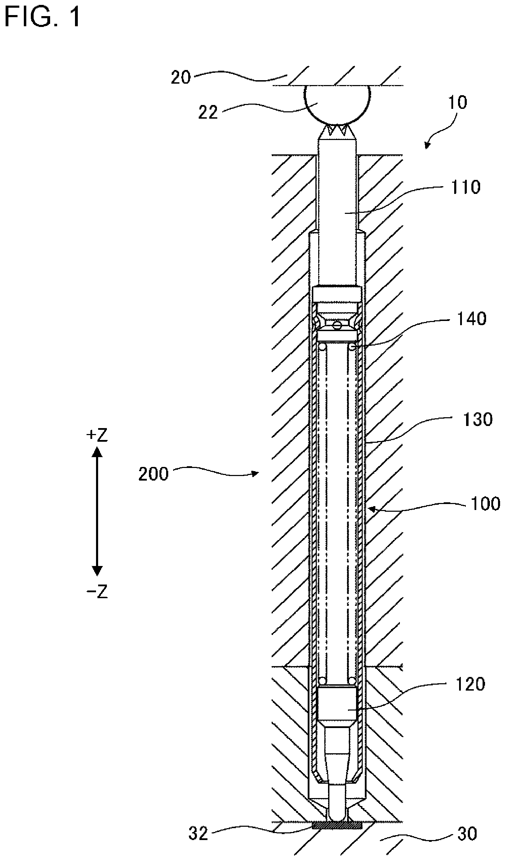

Fig. 1 is a cross-sectional view showing a socket 10 according to an embodiment.

In Fig. 1, the arrow indicated by "+ Z" indicates an upward direction in the vertical direction and the arrow indicated by "- Z" indicates a downward direction in the vertical direction. Hereinafter, as necessary, a direction orthogonal to the vertical direction will be referred to as a horizontal direction.

The socket 10 includes a probe 100 and an insulating support 200. The probe 100 is provided in a through-hole formed in the insulating support 200. The probe 100 includes a first plunger 110, a second plunger 120, a tube 130, and a spring 140. Fig. 1 shows a state in which an inspection object 20 is inspected by an inspection substrate 30 using the probe 100. Specifically, the state shown in Fig. 1 is a state in which a solder ball 22 of the inspection subject 20 and a pad 32 of the inspection substrate 30 are electrically connected to each other via the probe 100.

The tube 130 extends in the vertical direction. The spring 140 is positioned inside the tube 130. The probe 100 may include no tube 130. The spring 140 is spirally wound around a virtual axis passing through the center of the tube 130 in the vertical direction.

The first plunger 110 is positioned on an upper end side of the spring 140. The first plunger 110 is biased upward by the spring 140, that is, in a direction away from the second plunger 120. When the inspection object 20 is inspected by the inspection substrate 30, the first plunger 110 is connected to the inspection object 20 positioned above the probe 100, and the distal end, that is, the upper end of the first plunger 110 is in contact with the solder ball 22 of the inspection object 20. In the example shown in Fig. 1, the distal end of the first plunger 110 has a plurality of sharp points arranged at equal intervals around a virtual axis passing through the center of the first plunger 110 in the vertical direction. The shape of the distal end of the first plunger 110 is not limited to the example shown in Fig. 1.

The second plunger 120 is positioned on a lower end side of the spring 140. The second plunger 120 is biased downward by the spring 140, that is, in a direction away from the first plunger 110. When the inspection object 20 is inspected by the inspection substrate 30, the second plunger 120 is connected to the inspection substrate 30 positioned below the probe 100, and the distal end, that is, the lower end of the second plunger 120 is in contact with the pad 32 of the inspection substrate 30. The distal end of the second plunger 120 is hemispherical. The shape of the distal end of the second plunger 120 is not limited to the example shown in Fig. 1.

In the first aspect, the first plunger 110 contains a material (A). The material (A) contains greater than 20 mass% and less than or equal to 60 mass% of Pd, greater than or equal to 3 mass% and less than 20 mass% of Ag, greater than or equal to 3 mass% and less than or equal to 50 mass% of Ni, and greater than or equal to 3 mass% and less than or equal to 74 mass% of Cu. For example, at least the surface of the first plunger 110 is made of the material (A). For example, the entirety of the first plunger 110 may be formed of the material (A). Alternatively, the material (A) may cover the surface of the first plunger 110 by a treatment such as plating. When the material (A) covers the surface of the first plunger 110, a part of the first plunger 110 covered with the material (A) may be formed of a material different from the material (A). In addition, for example, at least a part of the first plunger 110 in contact with the solder ball 22 may be made of the material (A). For example, the material (A) may cover only the surface of the part of the first plunger 110 in contact with the solder ball 22 by a treatment such as plating.

The lower limit of the mass ratio of Pd contained in the material (A) is, for example, determined from the viewpoint of the corrosion resistance of the material (A). When the mass ratio of Pd contained in the material (A) is less than or equal to 20 mass%, the corrosion resistance of the material (A) may be insufficient. Since the corrosion resistance of the material (A) may be insufficient when the mass ratio of Pd contained in the material (A) is less than or equal to 20 mass%, the mass ratio of Pd contained in the material (A) can be greater than 20 mass%. The mass ratio of Pd contained in the material (A) may be, for example, greater than or equal to 22 mass% or greater than or equal to 25 mass%.

The upper limit of the mass ratio of Pd contained in the material (A) is determined, for example, from the viewpoint of suppressing diffusion between the component contained in the material (A) and the component contained in the solder such as the solder ball 22. When the mass ratio of Pd contained in the material (A) is greater than 60 mass%, it may be difficult to sufficiently suppress the diffusion between the component contained in the material (A) and the component contained in the solder. To sufficiently suppress the diffusion between the component contained in the material (A) and the component contained in the solder, the mass ratio of Pd contained in the material (A) can be less than or equal to 60 mass%. The mass ratio of Pd contained in the material (A) may be, for example, less than or equal to 55 mass% or less than or equal to 50 mass%.

The mass ratio of Pd contained in the material (A) can be, for example, greater than or equal to 22 mass% and less than or equal to 55 mass%. Alternatively, the mass ratio of Pd contained in the material (A) can be, for example, greater than or equal to 25 mass% and less than or equal to 50 mass%.

The lower limit of the mass ratio of Ag contained in the material (A) is determined, for example, from the viewpoint of age hardening. The combination of Ag, Pd, and Cu can improve the age hardening of the material (A). When the mass ratio of Ag contained in the material (A) is less than 3 mass%, the age hardening of the material (A) may be insufficient. Since the age hardening of the material (A) may be insufficient when the mass ratio of Ag contained in the material (A) is less than 3 mass%, the mass ratio of Ag contained in the material (A) can be greater than or equal to 3 mass%. The mass ratio of Ag contained in the material (A) may be, for example, greater than or equal to 4 mass%.

The upper limit of the mass ratio of Ag contained in the material (A) is determined, for example, from the viewpoint of relatively reducing the mass ratio of Ag contained in the material (A). From the viewpoint of relatively reducing the mass ratio of Ag contained in the material (A), the mass ratio of Ag contained in the material (A) can be less than 20 mass%. The mass ratio of Ag contained in the material (A) may be, for example, less than or equal to 18 mass%.

The mass ratio of Ag contained in the material (A) may be, for example, greater than or equal to 4 mass% and less than or equal to 18 mass%.

The lower limit of the mass ratio of Ni included in the material (A) is determined, for example, from the viewpoint of the mass ratio of Ag contained in the material (A) and from the viewpoint of suppressing the diffusion between the component contained in the material (A) and the component contained in the solder such as the solder ball 22. In the first aspect, the mass ratio of Ag contained in the material (A) is relatively small of less than 20 mass%. When the mass ratio of Ag contained in the material (A) is less than 20 mass% and the mass ratio of Ni contained in the material (A) is less than 3 mass%, it may be difficult to sufficiently suppress the diffusion between the component contained in the material (A) and the component contained in the solder. To sufficiently suppress the diffusion between the component contained in the material (A) and the component contained in the solder, the mass ratio of Ni contained in the material (A) can be greater than or equal to 3 mass%. The mass ratio of Ni contained in the material (A) may be, for example, greater than or equal to 5 mass% or greater than or equal to 7 mass%.

The upper limit of the mass ratio of Ni contained in the material (A) is determined, for example, from the viewpoint of plastic working such as cold rolling and wire drawing of the material (A). When the mass ratio of Ni contained in the material (A) is greater than 50 mass%, the plastic working such as cold rolling and wire drawing of the material (A) may be difficult. To prevent the plastic working such as cold rolling or wire drawing of the material (A) from being difficult, the mass ratio of Ni contained in the material (A) can be less than or equal to 50 mass%. The mass ratio of Ni contained in the material (A) may be, for example, less than or equal to 40 mass% or less than or equal to 35 mass%.

The mass ratio of Ni contained in the material (A) may be, for example, greater than or equal to 5 mass% and less than or equal to 40 mass%. Alternatively, the mass ratio of Ni contained in the material (A) may be, for example, greater than or equal to 7 mass% and less than or equal to 35 mass%.

The lower limit of the mass ratio of Cu contained in the material (A) is determined, for example, from the viewpoint of the hardness of the material (A). The hardness of the material (A) can be improved by an alloy of Pd and Cu. In addition, the specific resistance of Cu is relatively low. When the mass ratio of Cu contained in the material (A) is less than 3 mass%, it may be difficult to ensure sufficient hardness of the material (A). Since it may be difficult to ensure the hardness of the material (A) when the mass ratio of Cu contained in the material (A) is less than 3 mass%, the mass ratio of Cu contained in the material (A) can be greater than or equal to 3 mass%. The mass ratio of Cu contained in the material (A) may be, for example, greater than or equal to 5 mass%, greater than or equal to 10 mass%, or greater than or equal to 15 mass%.

The upper limit of the mass ratio of Cu contained in the material (A) is determined, for example, from the viewpoint of the corrosion resistance of the material (A). When the mass ratio of Cu contained in the material (A) is greater than 74 mass%, it may be difficult to ensure sufficient corrosion resistance of the material (A). Since it may be difficult to ensure sufficient corrosion resistance of the material (A) when the mass ratio of Cu contained in the material (A) is greater than 74 mass%, the mass ratio of Cu contained in the material (A) can be less than or equal to 74 mass%. The mass ratio of Cu contained in the material (A) may be, for example, less than or equal to 70 mass%, less than or equal to 60 mass%, or less than or equal to 50 mass%.

The mass ratio of Cu contained in the material (A) may be, for example, greater than or equal to 5 mass% and less than or equal to 70 mass%. Alternatively, the mass ratio of Cu contained in the material (A) may be, for example, greater than or equal to 10 mass% and less than or equal to 60 mass%. Alternatively, the mass ratio of Cu contained in the material (A) may be, for example, greater than or equal to 15 mass% and less than or equal to 50 mass%.

The material (A) may contain greater than or equal to 0.2 mass% and less than or equal to 2.0 mass% of at least one of In, Sn, Zn, or Ga in a total amount in place of a part of Cu.

The lower limit of the total mass ratio of at least one of In, Sn, Zn, or Ga, which is contained in the material (A), is determined, for example, from the viewpoint of the age hardening of the material (A). The age hardening of the material (A) when the total mass ratio of the at least one kind contained in the material (A) is less than 0.2 mass% is almost the same as the age hardening of the material (A) that does not contain the at least one kind. Since the age hardening of the material (A) is almost the same as the age hardening of the material (A) that does not contain the at least one kind, the total mass ratio of the at least one kind contained in the material (A) can be greater than or equal to 0.2 mass%. The total mass ratio of the one kind contained in the material (A) may be, for example, greater than or equal to 0.3 mass%.

The upper limit of the total mass ratio of at least one of In, Sn, Zn, or Ga contained in the material (A) is determined, for example, from the viewpoint of the plastic working such as cold rolling or wire drawing of the material (A). When the total mass ratio of the at least one kind contained in the material (A) is greater than 2.0 mass%, it may be difficult to perform plastic working such as cold rolling or wire drawing of the material (A). Since it may be difficult to perform plastic working such as cold rolling or wire drawing of the material (A) when the total mass ratio of the at least one kind contained in the material (A) is greater than 2.0 mass%, the upper limit of the total mass ratio of the at least one kind contained in the material (A) can be less than or equal to 2.0 mass%. The total mass ratio of the at least one kind contained in the material (A) may be, for example, less than or equal to 1.5 mass%.

The total mass ratio of at least one of In, Sn, Zn, or Ga contained in the material (A) may be, for example, greater than or equal to 0.3 mass% and less than or equal to 1.5 mass%.

In the second aspect, the first plunger 110 contains a material (B) in place of the material (A). The material (B) contains greater than 20 mass% and less than or equal to 60 mass% of Pd, greater than or equal to 20 mass% and less than or equal to 35 mass% of Ag, greater than or equal to 7 mass% and less than or equal to 50 mass% of Ni, and greater than or equal to 3 mass% and less than or equal to 53 mass% of Cu. For example, at least the surface of the first plunger 110 is made of the material (B). In the example in which at least the surface of the first plunger 110 is made of the material (B), for example, the entire first plunger 110 may be formed of the material (B). Alternatively, the material (B) may cover the surface of the first plunger 110 by a treatment such as plating. When the material (B) covers the surface of the first plunger 110, a part of the first plunger 110 covered with the material (B) may be formed of a material different from the material (B). In addition, for example, at least a part of the first plunger 110 that is in contact with the solder ball 22 may be made of the material (B). In the example in which at least a part of the first plunger 110 in contact with the solder ball 22 is made of the material (B), for example, the material (B) may cover only the surface of the part of the first plunger 110 in contact with the solder ball 22 by a treatment such as plating.

The lower limit of the mass ratio of Pd contained in the material (B) is determined from the viewpoint of the corrosion resistance of the material (B), for example, in the same manner as that for the lower limit of the mass ratio of Pd contained in the material (A). From the viewpoint of the corrosion resistance of the material (B), the mass ratio of Pd contained in the material (B) can be greater than 20 mass%. The mass ratio of Pd contained in the material (B) may be, for example, greater than or equal to 22 mass% or greater than or equal to 25 mass%.

The upper limit of the mass ratio of Pd contained in the material (B) is determined from the viewpoint of suppressing the diffusion between the component contained in the material (B) and the component contained in the solder such as the solder ball 22, for example, in the same manner as that for the upper limit of the mass ratio of Pd contained in the material (A). From the viewpoint of suppressing the diffusion between the component contained in the material (B) and the component contained in the solder such as the solder ball 22, the mass ratio of Pd contained in the material (B) can be less than or equal to 60 mass%. The mass ratio of Pd contained in the material (B) may be, for example, less than or equal to 55 mass% or less than or equal to 50 mass%.

The mass ratio of Pd contained in the material (B) may be, for example, greater than or equal to 22 mass% and less than or equal to 55 mass%. Alternatively, the mass ratio of Pd contained in the material (B) may be, for example, greater than or equal to 25 mass% and less than or equal to 50 mass%.

The lower limit of the mass ratio of Ag contained in the material (B) is determined, for example, from the viewpoint of relatively large mass ratio of Ag contained in the material (B). From the viewpoint of relatively large mass ratio of Ag contained in the material (B), the mass ratio of Ag contained in the material (B) can be greater than 20 mass%. The mass ratio of Ag contained in the material (B) may be, for example, greater than or equal to 21 mass%.

The upper limit of the mass ratio of Ag contained in the material (B) is determined, for example, from the viewpoint of suppressing the diffusion between the component contained in the material (B) and the component contained in the solder such as the solder ball 22. When the mass ratio of Ag contained in the material (B) is greater than 35 mass%, it may be difficult to sufficiently suppress the diffusion between the component contained in the material (B) and the component contained in the solder. Since it may be difficult to sufficiently suppress the diffusion between the component contained in the material (B) and the component contained in the solder when the mass ratio of Ag contained in the material (B) is greater than 35 mass%, the mass ratio of Ag contained in the material (B) can be less than or equal to 35 mass%. The mass ratio of Ag contained in the material (B) may be, for example, less than or equal to 33 mass%.

The mass ratio of Ag contained in the material (B) may be, for example, greater than or equal to 21 mass% and less than or equal to 33 mass%.

The lower limit of the mass ratio of Ni contained in the material (B) is determined, for example, from the viewpoint of the mass ratio of Ag contained in the material (B) and the viewpoint of suppressing the diffusion between the component contained in the material (B) and the component contained in the solder such as the solder ball 22. In the second aspect, the mass ratio of Ag contained in the material (B) is relatively large of greater than or equal to 20 mass%. When the mass ratio of Ag contained in the material (B) is relatively large of greater than or equal to 20 mass% and the mass ratio of Ni contained in the material (B) is less than 7 mass%, it may be difficult to sufficiently suppress the diffusion between the component contained in the material (B) and the component contained in the solder. To sufficiently suppress the diffusion between the component contained in the material (B) and the component contained in the solder, the mass ratio of Ni contained in the material (B) can be greater than or equal to 7 mass%. The mass ratio of Ni contained in the material (B) may be, for example, greater than or equal to 8 mass%, greater than or equal to 10 mass%, or greater than or equal to 11 mass%.

The upper limit of the mass ratio of Ni contained in the material (B) is determined from the viewpoint of plastic working such as cold rolling or wire drawing of the material (B), for example, in the same manner as that for the upper limit of the mass ratio of Ni contained in the material (A). From the viewpoint of plastic working such as cold rolling or wire drawing of the material (B), the mass ratio of Ni contained in the material (B) can be less than or equal to 50 mass%. The mass ratio of Ni contained in the material (B) may be, for example, less than or equal to 40 mass% or less than or equal to 35 mass%.

The mass ratio of Ni contained in the material (B) may be, for example, greater than or equal to 8 mass% and less than or equal to 40 mass%. Alternatively, the mass ratio of Ni contained in the material (B) may be, for example, greater than or equal to 10 mass% and less than or equal to 35 mass%. Alternatively, the mass ratio of Ni contained in the material (B) may be, for example, greater than or equal to 11 mass% and less than or equal to 35 mass%.

The lower limit of the mass ratio of Cu contained in the material (B) is determined from the viewpoint of the hardness of the material (B), for example, in the same manner as that for the lower limit of the mass ratio of Cu contained in the material (A). From the viewpoint of hardness of the material (B), the mass ratio of Cu contained in the material (B) can be greater than or equal to 3 mass%. The mass ratio of Cu contained in the material (B) may be, for example, greater than or equal to 5 mass% or greater than or equal to 10 mass%.

The upper limit of the mass ratio of Cu contained in the material (B) is determined from the viewpoint of the corrosion resistance of the material (B), for example, in the same manner as that for the upper limit of the mass ratio of Cu contained in the material (A). From the viewpoint of the corrosion resistance of the material (B), the mass ratio of Cu contained in the material (B) can be less than or equal to 53 mass%. The mass ratio of Cu included in the material (B) may be, for example, less than or equal to 47 mass% or less than or equal to 40 mass%.

The mass ratio of Cu contained in the material (B) may be, for example, greater than or equal to 5 mass% and less than or equal to 47 mass%. Alternatively, the mass ratio of Cu included in the material (B) may be, for example, greater than or equal to 10 mass% and less than or equal to 40 mass%.

The material (B) may contain greater than or equal to 0.2 mass% and less than or equal to 2.0 mass% of at least one of In, Sn, Zn, or Ga in a total amount in place of a part of Cu.

The lower limit of the total mass ratio of at least one of In, Sn, Zn, or Ga contained in the material (B) is determined from the viewpoint of the age hardening of the material (B), for example, in the same manner as that for the lower limit of the total mass ratio of at least one of In, Sn, Zn, or Ga contained in the material (A). From the viewpoint of the age hardening of the material (B), the total mass ratio of the one kind contained in the material (B) can be greater than or equal to 0.2 mass%. The total mass ratio of the one kind contained in the material (B) may be, for example, greater than or equal to 0.3 mass%.

The upper limit of the total mass ratio of at least one of In, Sn, Zn, or Ga contained in the material (B) is determined from the viewpoint of the plastic working such as cold rolling or wire drawing of the material (B), for example, in the same manner as that for the upper limit of the total mass ratio of at least one of In, Sn, Zn, or Ga contained in the material (A). From the viewpoint of the plastic working such as cold rolling or wire drawing of the material (B), the upper limit of the total mass ratio of the at least one kind contained in the material (B) can be less than or equal to 2.0 mass%. The total mass ratio of the at least one kind contained in the material (B) may be, for example, less than or equal to 1.5 mass%.

The total mass ratio of at least one of In, Sn, Zn, or Ga contained in the material (B) may be, for example, greater than or equal to 0.3 mass% and less than or equal to 1.5 mass%.

Hereinafter, an alloy of Pd, Ag, and Cu without Ni will be referred to as a PdAgCu alloy.

In the embodiment, the diffusion of the component contained in the first plunger 110 into the solder ball 22 at the interface between the distal end of the first plunger 110 and the surface of the solder ball 22 can be suppressed as compared with a case where the first plunger 110 contains the PdAgCu alloy. In addition, in the embodiment, the diffusion of the component contained in the first plunger 110 into the solder ball 22 is suppressed so that the wearing of the distal end of the first plunger 110 can be suppressed as compared with a case where the first plunger 110 contains the PdAgCu alloy.

The reason why the diffusion of the component contained in the material (A) into the solder is suppressed when the material (A) is used as compared with a case where the PdAgCu alloy is used is presumed to be as follows. That is, upon contact between the material (A) and the solder, a dense thin film containing a metal compound such as Sn-Ni is formed at an interface between the material (A) and the solder due to Ni contained in the material (A). The diffusion of the components contained in the material (A) and the solder is suppressed by the metal compound when the metal compound is present at the interface between the material (A) and the solder as compared with when the metal compound is not present at the interface between the material (A) and the solder. When the PdAgCu alloy is used, in contrast, the above-described metal compound is unlikely to be formed. Accordingly, the diffusion of the component contained in the first plunger 110 into the solder ball 22 between the distal end of the first plunger 110 and the solder ball 22 can be suppressed in the embodiment as compared with a case where the first plunger 110 contains the PdAgCu alloy. The diffusion of the component contained in the material (B) into the solder can be suppressed also when the material (B) is used as compared with a case where the PdAgCu alloy is used for the same reason as described above.

The material (A) or the material (B) is not required to have a hardness as high as the hardness of an existing PdAgCu alloy. However, the contact surface of the first plunger 110 may be mechanically crushed as the number of times of inspection increases. It is desirable that the material (A) or the material (B) is relatively hard because the contact surface of the first plunger 110 may be mechanically crushed as the number of times of inspection increases. For example, the first plunger 110 is usable in a case of a hardness of 200 HV or more. In the embodiment, the material (A) or the material (B) can have a hardness of 250 HV or more. The hardness of the material (A) or the material (B) may be a processing material hardness due to processing or may be an aging material hardness due to aging treatment.

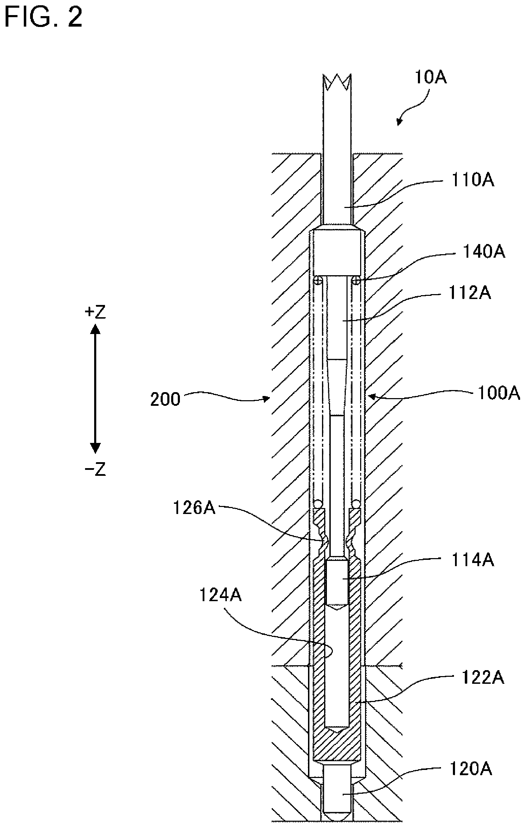

Fig. 2 is a cross-sectional view of a socket 10A according to a first variant. The socket 10A according to the present variant is the same as the probe 100 according to the embodiment except for the following points.

A lower end of the first plunger 110A is provided with an extending portion 112A extending downward from the first plunger 110A. The first plunger 110A and the extending portion 112A are integrated with each other. Accordingly, both the first plunger 110A and the extending portion 112A contain the material (A) or the material (B). The distal end head 114A is provided at a lower end of the extending portion 112A. The distal end head 114A may or may not contain the material (A) or the material (B).

A proximal end portion 122A is provided at an upper end of the second plunger 120A. A hole 124A open toward the upper portion of the proximal end portion 122A is formed on an upper surface of the proximal end portion 122A. A locking portion 126A is provided on a part of the inner wall of the proximal end portion 122A defining the hole 124A. The diameter of the hole 124A in the locking portion 126A in the horizontal direction is less than the diameter of the hole 124A in a portion positioned below the locking portion 126A in the horizontal direction. The distal end head 114A is located below the locking portion 126A in the hole 124A. The distal end head 114A is movable in the vertical direction below the locking portion 126A in the hole 124A. The diameter of the distal end head 114A in the horizontal direction is greater than the diameter of the hole 124A in the locking portion 126A in the horizontal direction. Accordingly, the locking portion 126A prevents the distal end head 114A from moving upwardly through the hole 124A.

The probe 100A according to the present variant does not have a tube corresponding to the tube 130 of the probe 100 according to the embodiment. The spring 140A is positioned between the lower end of the first plunger 110A and the upper end of the proximal end portion 122A. The spring 140A is spirally wound around the extending portion 112A. The first plunger 110A, the extending portion 112A, and the distal end head 114A are biased upward by the spring 140A. The second plunger 120A and the proximal end portion 122A are biased downward by the spring 140A.

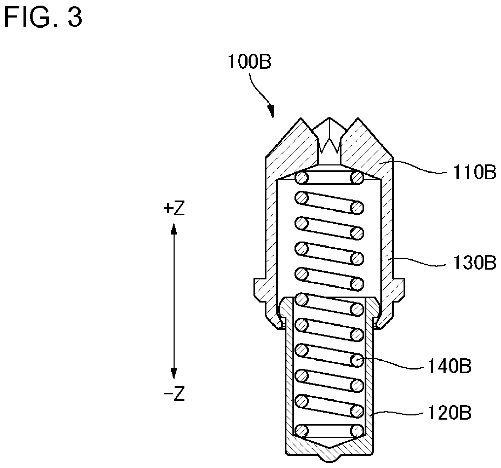

Fig. 3 is a cross-sectional view of a probe 100B according to a second variant. The probe 100B according to the present variant is the same as the probe 100 according to the embodiment except for the following points.

In the example shown in Fig. 3, the first plunger 110B and the tube 130B are integrated with each other. Accordingly, both the first plunger 110B and the tube 130B contain the material (A) or the material (B). The first plunger 110B and the tube 130B are biased upward by the spring 140B, that is, in a direction away from the second plunger 120B. The second plunger 120B is biased downward by the spring 140B, that is, in a direction away from the first plunger 110B.

Although the embodiments and variants of the present invention have been described with reference to the accompanying drawings, these are merely examples of the present invention, and various other configurations may be employed.

Examples

One aspect of the present invention will be described based on examples and comparative examples. The present invention is not limited to the following examples.

Table 1 is a table listing the composition (unit: mass%) of Pd, Ag, Ni, Cu, In, Sn, Zn, and Ga contained in each of the test materials of Examples 1 to 20 and Comparative Examples 1 to 10.

[Table 1]

| | Composition (mass%) | | | | | | | |
|---|---|---|---|---|---|---|---|---|
| | Pd | Ag | Ni | Cu | In | Sn | Zn | Ga |
| Example 1 | 45 | 3 | 10 | 42 | | | | |
| Example 2 | 43 | 5 | 10 | 42 | | | | |

(continued)

| | Composition (mass%) | | | | | | | |
|---|---|---|---|---|---|---|---|---|
| | Pd | Ag | Ni | Cu | In | Sn | Zn | Ga |
| Example 3 | 33 | 15 | 10 | 42 | | | | |
| Example 4 | 30 | 20 | 10 | 40 | | | | |
| Example 5 | 30 | 30 | 10 | 30 | | | | |
| Example 6 | 38 | 10 | 30 | 22 | | | | |
| Example 7 | 45 | 10 | 5 | 40 | | | | |
| Example 8 | 40 | 25 | 10 | 25 | | | | |
| Example 9 | 30 | 25 | 30 | 15 | | | | |
| Example 10 | 40 | 10 | 10 | 39.5 | | 0.5 | | |
| Example 11 | 40 | 10 | 10 | 39.5 | | | 0.5 | |
| Example 12 | 40 | 10 | 10 | 39.5 | | | | 0.5 |
| Example 13 | 40 | 10 | 10 | 39.2 | 0.2 | 0.2 | 0.2 | 0.2 |
| Example 14 | 40 | 10 | 10 | 38.5 | 1.5 | | | |
| Example 15 | 40.5 | 22 | 10 | 27 | 0.5 | | | |
| Example 16 | 40 | 25 | 10 | 24.5 | | 0.5 | | |
| Example 17 | 40 | 25 | 10 | 24.5 | | | 0.5 | |
| Example 18 | 40 | 25 | 10 | 24.5 | | | | 0.5 |
| Example 19 | 40 | 25 | 10 | 24.2 | 0.2 | 0.2 | 0.2 | 0.2 |
| Example 20 | 40 | 25 | 10 | 23.5 | 1.5 | | | |
| Comparative Example 1 | 45 | 24.5 | | 30 | 0.5 | | | |
| Comparative Example 2 | 30 | 40 | 10 | 20 | | | | |
| Comparative Example 3 | 47 | 10 | 1 | 42 | | | | |
| Comparative Example 4 | 20 | 10 | 60 | 10 | | | | |
| Comparative Example 5 | 40 | 25 | 6 | 29 | | | | |
| Comparative Example 6 | 44.5 | 24.3 | 1 | 29.7 | 0.5 | | | |
| Comparative Example 7 | 43.6 | 23.8 | 3 | 29.1 | 0.5 | | | |
| Comparative Example 8 | 42.7 | 23.3 | 5 | 28.5 | 0.5 | | | |
| Comparative Example 9 | 40 | 25 | 10 | 22.5 | 2.5 | | | |
| Comparative Example 10 | 75 | | 10 | 15 | | | | |

Each of the test materials of Examples 1 to 20 and Comparative Examples 1 to 10 was prepared as follows.

In Example 1, as listed in Table 1, 45 mass% of Pd, 3 mass% of Ag, 10 mass% of Ni, and 42 mass% of Cu were blended to obtain a blended material. Also in each of Examples 2 to 20 and Comparative Examples 1 to 10, blended materials were obtained by blending Pd, Ag, Ni, Cu, In, Sn, Zn, and Ga to have the compositions of Examples 2 to 20 and Comparative Examples 1 to 10 listed in Table 1. The blanks in the columns of the compositions listed in Table 1 denote that the metals corresponding to the blanks were not blended.

Next, in each of Examples 1 to 20 and Comparative Examples 1 to 10, the blended material was melted by arc melting in an argon atmosphere, thereby preparing an alloy ingot.

Next, in each of Examples 1 to 20 and Comparative Examples 1 to 10, rolling and a heat treatment for the alloy ingot were repeatedly performed to prepare a plate material having a rolling rate of 75%. A rolling rate RR is determined according to Equation (1):

$$RR = \{(t1 - t2)/t1\} \times 100 \quad (1),$$

where t1 is a thickness of the alloy ingot before rolling and t2 is a thickness of the alloy ingot after rolling.

In Examples 1 to 20 and Comparative Examples 1, 3, 5 to 8, and 10, a plate material having a rolling rate of 75% could be prepared. In Comparative Examples 4 and 9, on the other hand, a plate material having a rolling rate of 75% could not be prepared. The measurement described below in Table 2 was not performed for Comparative Examples 4 and 9.

Table 2 is a table listing the measurement results of the specific resistance of the test material, the processing material hardness of the test material, the aging material hardness of the test material, and the thickness of the diffusion layer between the test material and the solder for each of Examples 1 to 20 and Comparative Examples 1, 3, 5 to 8, and 10.

[Table 2]

| | Specific resistance ($\mu\Omega\cdot$cm) | Processing material hardness (HV) | Aging material hardness (HV) | Thickness of diffusion layer ($\mu$m) |
|---|---|---|---|---|
| Example 1 | 46 | 300 | 320 | 20 |
| Example 2 | 44 | 310 | 330 | 20 |
| Example 3 | 46 | 290 | 330 | 15 |
| Example 4 | 44 | 300 | 330 | 45 |
| Example 5 | 44 | 280 | 320 | 65 |
| Example 6 | 38 | 350 | 370 | 10 |
| Example 7 | 35 | 330 | 350 | 25 |
| Example 8 | 30 | 320 | 350 | 40 |
| Example 9 | 25 | 320 | 340 | 10 |
| Example 10 | 39 | 340 | 370 | 20 |
| Example 11 | 38 | 330 | 360 | 20 |
| Example 12 | 41 | 330 | 370 | 20 |
| Example 13 | 40 | 330 | 380 | 15 |
| Example 14 | 42 | 340 | 360 | 30 |
| Example 15 | 34 | 330 | 370 | 15 |
| Example 16 | 39 | 320 | 370 | 20 |
| Example 17 | 38 | 310 | 360 | 25 |
| Example 18 | 29 | 320 | 360 | 20 |
| Example 19 | 30 | 320 | 370 | 20 |
| Example 20 | 38 | 340 | 360 | 30 |
| Comparative Example 1 | 25 | 350 | 550 | 600 or more |
| Comparative Example 2 | 39 | 270 | 320 | 215 |
| Comparative Example 3 | 27 | 320 | 340 | 600 or more |
| Comparative Example 5 | 28 | 320 | 360 | 240 |
| Comparative Example 6 | 26 | 340 | 540 | 370 |
| Comparative Example 7 | 31 | 350 | 460 | 600 or more |
| Comparative Example 8 | 27 | 340 | 410 | 360 |
| Comparative Example 10 | 43 | 290 | 300 | 600 or more |

In each of Examples 1 to 20 and Comparative Examples 1, 3, 5 to 8, and 10, the specific resistance of the test material was measured by measuring an electrical resistance R of the test material at room temperature and calculating a specific resistance $\rho$ according to Equation (2):

$$\rho = RS/l \quad (2),$$

where l is a measurement length of the test material in a direction in which the current flows, and S is a cross-sectional area of the test material perpendicular to the direction in which the current flows.

As listed in Table 2, in Examples 1 to 20 and Comparative Examples 1, 3, 5 to 8, and 10, the specific resistance was 50 $\mu\Omega\cdot$cm or less. Accordingly, the specific resistance required for the probe could be obtained in Examples 1 to 20.

In each of Examples 1 to 20 and Comparative Examples 1, 3, 5 to 8, and 10, the processing material hardness of the test material was measured by holding the center of the cross section of the test material with a load of 200 gf for 10 seconds using a micro Vickers hardness tester.

As listed in Table 2, in Examples 1 to 20 and Comparative Examples 1, 3, 5 to 8, and 10, the processing material hardness was 250 HV or more. Accordingly, the hardness required for the probe could be obtained in Examples 1 to 20.

In each of Examples 1 to 20 and Comparative Examples 1, 3, 5 to 8, and 10, the aging material hardness of the test material was measured as follows. First, each test material was subjected to an age hardening treatment at 300°C to 400°C for 1 hour. Next, the aging material hardness of each test material was measured by holding the center of the cross section of the test material with a load of 200 gf for 10 seconds using a micro Vickers hardness tester.

As listed in Table 2, in Examples 1 to 20 and Comparative Examples 1, 3, 5 to 8, and 10, the aging material hardness was 300 HV or more. Accordingly, the hardness required for the probe could be obtained in Examples 1 to 20.

In each of Examples 1 to 20 and Comparative Examples 1, 3, 5 to 8, and 10, the thickness of the diffusion layer between the test material and the solder was measured as follows. First, a Sn-Bi solder was placed on a test material having a size of 10 mm $\times$ 10 mm $\times$ a thickness of 0.5 mm. Next, the test material and the Si-Bi solder were subjected to a heat treatment in a $N_2$ atmosphere at 250°C for 1 hour with the Sn-Bi solder placed on the test material, and the solder was melted on the test material. Next, the test material was embedded in a resin to expose a cross section including both the test material and the solder. Next, an interface between the test material and the solder was linearly analyzed using an electron probe microanalyzer (EPMA) in a direction perpendicular to the surface of the test material on which the solder was placed. The diffusion layer was deemed as a layer in which both Sn diffusing from the solder and Pd diffusing from the test material were present. The thickness of the diffusion layer was measured from the measurement results of the EPMA.

As listed in Table 2, in Comparative Examples 1 to 3, 5 to 8, and 10, the thickness of the diffusion layer was 200 $\mu$m or more. In Examples 1 to 20, on the other hand, the thickness of the diffusion layer was less than 100 $\mu$m. Accordingly, the diffusion of the components contained in the test material into the solder could be suppressed in Examples 1 to 20 as compared with Comparative Examples 1, 3, 5 to 8, and 10.

As shown in the results listed in Table 2, the diffusion of the components contained in the test material into the solder could be suppressed while the specific resistance, the processing material hardness, and the aging material hardness required for the probe were realized in the test materials according to Examples 1 to 20 as compared with the test materials according to Comparative Examples 1 to 3, 5 to 8, and 10.

According to the present specification, the following aspects are provided.

(Aspect 1)

Aspect 1 is a probe containing

greater than 20 mass% and less than or equal to 60 mass% of Pd,
greater than or equal to 3 mass% and less than 20 mass% of Ag,
greater than or equal to 3 mass% and less than or equal to 50 mass% of Ni, and
greater than or equal to 3 mass% and less than or equal to 74 mass% of Cu.

According to the aspect 1, the diffusion of the components contained in the probe into the solder at the interface between the probe and the solder can be suppressed as compared with a case where the probe contains an alloy consisting of Pd, Ag, and Cu without Ni.

(Aspect 2)

Aspect 2 is the probe according to Aspect 1, in which the probe contains greater than or equal to 0.2 mass% and less than or equal to 2.0 mass% of at least one of In, Sn, Zn, or Ga in place of a part of the Cu.

According to Aspect 2, the diffusion of the components contained in the probe into the solder at the interface between the probe and the solder can be suppressed as compared with a case where the probe contains an alloy consisting of Pd, Ag, and Cu without Ni.

(Aspect 3)

Aspect 3 is a probe containing

greater than 20 mass% and less than or equal to 60 mass% of Pd,
greater than or equal to 20 mass% and less than or equal to 35 mass% of Ag,
greater than or equal to 7 mass% and less than or equal to 50 mass% of Ni, and
greater than or equal to 3 mass% and less than or equal to 53 mass% of Cu.

According to the aspect 3, the diffusion of the components contained in the probe into the solder at the interface between the probe and the solder can be suppressed as compared with a case where the probe contains an alloy consisting of Pd, Ag, and Cu without Ni.

(Aspect 4)

Aspect 4 is the probe according to Aspect 3, in which the probe contains greater than or equal to 0.2 mass% and less than or equal to 2.0 mass% of at least one of In, Sn, Zn, or Ga in place of a part of the Cu.
According to Aspect 4, the diffusion of the components contained in the probe into the solder at the interface between the probe and the solder can be suppressed as compared with a case where the probe contains an alloy consisting of Pd, Ag, and Cu without Ni.
This application claims priority based on Japanese Patent Application No. 2022-052834, filed March 29, 2022, the entire content of which is incorporated herein by reference.

REFERENCE SIGNS LIST

10, 10A socket, 20 inspection object, 22 ball, 30 inspection substrate, 32 pad, 100, 100A, 100B probe, 110, 110A, 110B first plunger, 112A extending portion, 114A distal end head, 120, 120A, 120B second plunger, 122A proximal end portion, 124A hole, 126A locking portion, 130, 130B tube, 140, 140A, 140B spring, 200 insulating support

**Claims**

1. A probe comprising:

   greater than 20 mass% and less than or equal to 60 mass% of Pd;
   greater than or equal to 3 mass% and less than 20 mass% of Ag;
   greater than or equal to 3 mass% and less than or equal to 50 mass% of Ni; and
   greater than or equal to 3 mass% and less than or equal to 74 mass% of Cu.

2. The probe according to Claim 1,
   wherein the probe includes greater than or equal to 0.2 mass% and less than or equal to 2.0 mass% of at least one of In, Sn, Zn, or Ga in place of a part of the Cu.

3. A probe comprising:

   greater than 20 mass% and less than or equal to 60 mass% of Pd;
   greater than or equal to 20 mass% and less than or equal to 35 mass% of Ag;
   greater than or equal to 7 mass% and less than or equal to 50 mass% of Ni; and
   greater than or equal to 3 mass% and less than or equal to 53 mass% of Cu.

4. The probe according to Claim 3,
   wherein the probe includes greater than or equal to 0.2 mass% and less than or equal to 2.0 mass% of at least one of In, Sn, Zn, or Ga in place of a part of the Cu.

FIG. 1

# FIG. 2

FIG. 3

## INTERNATIONAL SEARCH REPORT

| International application No. |
| --- |
| **PCT/JP2023/007722** |

### A. CLASSIFICATION OF SUBJECT MATTER

*C22C 5/04*(2006.01)i; *C22C 9/00*(2006.01)i; *C22C 30/02*(2006.01)i; *C22C 19/03*(2006.01)i; *C22F 1/00*(2006.01)i;
*C22F 1/08*(2006.01)i; *C22F 1/10*(2006.01)i; *C22F 1/14*(2006.01)i; *G01R 1/06*(2006.01)i
FI:   C22C5/04; C22C9/00; C22C19/03 M; C22C30/02; C22F1/00 602; C22F1/00 623; C22F1/00 625; C22F1/00 630C;
C22F1/00 630K; C22F1/00 661A; C22F1/00 661Z; C22F1/00 691B; C22F1/00 691C; C22F1/08 B; C22F1/10 A;
C22F1/14; G01R1/06 Z

According to International Patent Classification (IPC) or to both national classification and IPC

### B. FIELDS SEARCHED

Minimum documentation searched (classification system followed by classification symbols)

    C22C5/04; C22C9/00; C22C19/03; C22C30/02; C22F1/00; C22F1/08; C22F1/10; C22F1/14; G01R1/06

Documentation searched other than minimum documentation to the extent that such documents are included in the fields searched

    Published examined utility model applications of Japan 1922-1996
    Published unexamined utility model applications of Japan 1971-2023
    Registered utility model specifications of Japan 1996-2023
    Published registered utility model applications of Japan 1994-2023

Electronic data base consulted during the international search (name of data base and, where practicable, search terms used)

### C. DOCUMENTS CONSIDERED TO BE RELEVANT

| Category* | Citation of document, with indication, where appropriate, of the relevant passages | Relevant to claim No. |
| --- | --- | --- |
| A | WO 2013/099682 A1 (TOKURIKI HONTEN CO., LTD.) 04 July 2013 (2013-07-04)<br>   entire text | 1-4 |
| A | WO 2016/159316 A1 (NHK SPRING CO., LTD.) 06 October 2016 (2016-10-06)<br>   entire text | 1-4 |
| A | JP 2004-93355 A (TOSHIBA CORP.) 25 March 2004 (2004-03-25)<br>   entire text | 1-4 |
| A | JP 3574139 B2 (THE J. M. NEY CO.) 06 October 2004 (2004-10-06)<br>   entire text | 1-4 |
| A | JP 54-82343 A (SUWA SEIKOSHA K.K.) 30 June 1979 (1979-06-30)<br>   entire text | 1-4 |
| A | US 6210636 B1 (THE J. M. NEY CO.) 03 April 2001 (2001-04-03)<br>   entire text | 1-4 |

☐ Further documents are listed in the continuation of Box C.    ☑ See patent family annex.

| | |
| --- | --- |
| * Special categories of cited documents:<br>"A" document defining the general state of the art which is not considered to be of particular relevance<br>"E" earlier application or patent but published on or after the international filing date<br>"L" document which may throw doubts on priority claim(s) or which is cited to establish the publication date of another citation or other special reason (as specified)<br>"O" document referring to an oral disclosure, use, exhibition or other means<br>"P" document published prior to the international filing date but later than the priority date claimed | "T" later document published after the international filing date or priority date and not in conflict with the application but cited to understand the principle or theory underlying the invention<br>"X" document of particular relevance; the claimed invention cannot be considered novel or cannot be considered to involve an inventive step when the document is taken alone<br>"Y" document of particular relevance; the claimed invention cannot be considered to involve an inventive step when the document is combined with one or more other such documents, such combination being obvious to a person skilled in the art<br>"&" document member of the same patent family |

| Date of the actual completion of the international search | Date of mailing of the international search report |
| --- | --- |
| **10 April 2023** | **25 April 2023** |

| Name and mailing address of the ISA/JP | Authorized officer |
| --- | --- |
| **Japan Patent Office (ISA/JP)**<br>**3-4-3 Kasumigaseki, Chiyoda-ku, Tokyo 100-8915**<br>**Japan** | |
| | Telephone No. |

Form PCT/ISA/210 (second sheet) (January 2015)

| Patent document cited in search report | | | Publication date (day/month/year) | Patent family member(s) | | | Publication date (day/month/year) |
|---|---|---|---|---|---|---|---|
| WO | 2013/099682 | A1 | 04 July 2013 | US | 2014/0377129 | A1 | |
| | | | | CN | 104024448 | A | |
| | | | | KR | 10-2014-0113920 | A | |
| | | | | TW | 201333225 | A | |
| WO | 2016/159316 | A1 | 06 October 2016 | TW | 201702392 | A | |
| JP | 2004-93355 | A | 25 March 2004 | (Family: none) | | | |
| JP | 3574139 | B2 | 06 October 2004 | US | 5484569 | A | |
| | | | | WO | 1996/005330 | A1 | |
| | | | | EP | 769075 | A1 | |
| JP | 54-82343 | A | 30 June 1979 | (Family: none) | | | |
| US | 6210636 | B1 | 03 April 2001 | WO | 2000/066798 | A1 | |
| | | | | AU | 4043800 | A | |

Form PCT/ISA/210 (patent family annex) (January 2015)

**REFERENCES CITED IN THE DESCRIPTION**

**Patent documents cited in the description**

- US 1935897 A

- JP 2022052834 A